(19) 

Europäisches
Patentamt
European
Patent Office
Office européen
des brevets

(11) **EP 4 421 207 B1**

(12) **EUROPEAN PATENT SPECIFICATION**

(45) Date of publication and mention
of the grant of the patent:
**22.04.2026 Bulletin 2026/17**

(21) Application number: **23158463.2**

(22) Date of filing: **24.02.2023**

(51) International Patent Classification (IPC):
*C23C 14/00* (2006.01)   *C23C 14/08* (2006.01)
*C23C 14/18* (2006.01)   *C23C 14/20* (2006.01)
*C23C 14/34* (2006.01)   *C23C 14/35* (2006.01)
*C03C 17/36* (2006.01)   *C03C 17/245* (2006.01)
*C23C 28/00* (2006.01)

(52) Cooperative Patent Classification (CPC):
**C23C 14/0068; C03C 17/245; C03C 17/36;
C03C 17/3618; C03C 17/3642; C03C 17/3649;
C23C 14/083; C23C 14/18; C23C 14/185;
C23C 14/205; C23C 14/3485; C23C 14/35;
C23C 28/32; C23C 28/323; C23C 28/3455;** (Cont.)

(54) **AN ANTIMICROBIAL MULTILAYER THIN-FILM MATERIALS COATING**

ANTIMIKROBIELLER MEHRSCHICHTDÜNNFILMMATERIALÜBERZUG

REVÊTEMENT ANTIMICROBIEN DE MATÉRIAUX EN COUCHES MINCES

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(43) Date of publication of application:
**28.08.2024 Bulletin 2024/35**

(73) Proprietor: **Latvijas Universitates Cietvielu fizikas
instituts**
**1063 Riga (LV)**

(72) Inventors:
• **SKVORCOVA, Vera**
**1021 Riga (LV)**
• **ZUBKINS, Martins**
**1006 Riga (LV)**
• **PURANS, Juris**
**1010 Riga (LV)**
• **VIBORNIJS, Viktors**
**5701 Ludza (LV)**
• **STRODS, Edvards**
**1006 Riga (LV)**
• **AULIKA, Ilze**
**10040 Rubiana (TO) (IT)**
• **ZAJAKINA, Anna**
**1067 Riga (LV)**

• **KOROTKAJA, Ksenija**
**1067 Riga (LV)**
• **RUDEVICA, Zanna**
**1055 Riga (LV)**

(74) Representative: **Fortuna, Jevgenijs**
**Foral Patent Law Offices**
**Kaleju iela 14-7**
**1050 Riga (LV)**

(56) References cited:
**US-B2- 6 596 399**

• **KUZMIN A. ET AL: "X-ray absorption
spectroscopy of Cu-doped WO3 films for use in
electrochemical metallization cell memory",
JOURNAL OF NON-CRYSTALLINE SOLIDS, vol.
401, 1 October 2014 (2014-10-01), NL, pages 87 -
91, XP055795234, ISSN: 0022-3093, DOI: 10.1016/
j.jnoncrysol.2014.01.022**
• **RABIA D-E ET AL: "Stabilisation of Cu films in
WO3/Ag/Cu:Al/WO3structures through their
doping by Al and Ag", THIN SOLID FILMS, vol.
669, 29 November 2018 (2018-11-29), pages 613 -
619, XP085559926, ISSN: 0040-6090, DOI:
10.1016/J.TSF.2018.11.059**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)
C03C 2217/24; C03C 2218/156

**Description**

Technical Field

The invention relates to the field of antimicrobial-thin film coatings, in particular to vacuum deposition of transparent conductive coatings by magnetron sputtering.

Background Art

Bacterial surface fouling (biofouling) causes many severe problems in a rangeof applications, such as the biomedical field and food industry, which can result in enormous economic losses, pose threats to human health and even lead to death [1].It should be noted that the bactericidal effect of solid materials is manifested only when they come into direct contact with bacteria and viruses, i.e. it is due to the special properties of the surface layers of solid bactericidal materials.

The materials used as coatings with anti-bactericidal effect must meet a number of requirements: have bio- and antibacterial activity and have (high) good mechanical properties, wear resistance, and corrosion resistance.

The best-known and widely used solid inorganic bactericidal material is silver. Silver-based inorganic anti-microbial agents have been known as anti-microbial agents that have sustained efficacy against bacteria. The silver-based inorganic anti-microbial agents are anti-microbial agents, which comprise silver carried on an inorganic compound.Silver nanoparticles (Ag NPs) have been the most extensively studied and used antimicrobial nanoparticles, in part because they exhibited effective broad-spectrum antibacterial activity[2, 3]. However, Ag NPs also showed toxicity to human cells and organs [4, 5].Moreover, it is an expensive material and therefore its practical application is limited.

There is known bactericidal phosphate glass material [6], which is cheap compared to pure metallic silver solid inorganic oxide materials. There is known an anti-coronavirus agent containing a silver ion carrier [7]. The main disadvantage of the known controlled-release glass having two or more agents consisting of metals is its low hydrolytic resistance.

There is known an antimicrobial composite material and a process for its preparation [8], where at least one molybdenum- and/or tungsten- containing inorganic compound is bonded to at least one further material.

There is known a method for producing a doped mixed oxide for a composite material [9], which serves to form antimicrobials active surfaces.

It is known that a second material can be deposited to stabilize, protect and control the release of the metal, wherein the metal and a second material are deposited simultaneously or sequentially. The metal layer may comprise an optimized nanostructure. If the second material is over-coated onto the metal layer, the metal can diffuse through such a coating. The metal may be silver, copper, cobalt or nickel. Preferably, the metal precursor is delivered in aqueous solution and may be a soluble salt of the metal. The second material can be a metal oxide, preferably silica.The copper (II) ion is known as an effective ingredient for antimicrobial and antiviral properties. [10] discloses an antimicrobial and antiviral polymeric material having microscopic particles of ionic copper encapsulated therein and protruding form surfaces thereof.

There is known an antimicrobial glass article [11] comprising a glass substrate and copper-containing nanoparticles on a surface of the glass, the copper-containing nano particles being selected from the group consisting of $Cu^0$ nano particles, $Cu_2O$ nanometers and a combination of the above, wherein the antimicrobial glass has an anti-bacterial log reduction value of greater than or equal to 1 and an anti-viral log reduction value of greater than or equal to one. An antibacterial material containing tungsten oxide complex microparticles, characterized in that the tungsten oxide complex microparticles contain at least one metal element selected from the group consisting of Ti, Zr, Mn, Fe, Pd, Pt, Cu, Ag, Zn, Al and Ce is disclosed in [12].

Thereis known an antibacterial material having tungsten oxide microparticles and tungstenoxide composite microparticles [13].The tungsten oxide composite contains a tungsten oxide as a main component and a transition metalelement. According to the teaching of [14], at least one type of metal element is selected from Cu, Ag, and Zn, which can improve antiviralperformance.The antibacterial action of tungsten oxide is generally known [15-17].

Furtherantimicrobials effective surfaces are known from [18-22].

However, such antimicrobial coatings or objects do not always have a satisfactory coating quality or effectiveness and involve coating methods that are costly and complex to handle. It would therefore be desirable to provide an effective antimicrobial coating by simplifying the actual coating procedure.

Transition metal oxides represent a large family of possessing various properties such as colossal magneto-resistance, piezoelectricity and superconductivity. Among them, tungsten oxide is an n-type semiconductor metal oxide material, which has its band gap in the range of 2.6-3.0 eVand it can be irradiated by visible light [23]. $WO_3$ exhibits various crystal phases, which include monoclinic I ($\gamma$-$WO_3$), monoclinic II ($\varepsilon$- $WO_3$), and orthorhombic ($\beta$-$WO_3$). $\varepsilon$-$WO_3$ is not stable at high temperature[24], and it is usually become stable after doping with Cr or incorporating Si into the lattice of $WO_3$ [25].

The tungsten metal has several oxidation numbers, they form different compounds such as $W_3O$, $WO_2$, $WO_{2.72}$, $WO_{2.9}$, $WO_{2.96}$ and $WO_3$ [26] and shows several outstanding properties like electrochromic [27], gas chromic [28], photochromic [29], gas sensor [30], photocatalyst [31] and photoluminescence properties [32]. To modify the electronic structure and their surface properties of semiconductor, the chemical doping of $WO_3$ with metallic elements are used extending their visible light absorbance. Copper (Cu) doped $WO_3$ has attracted a great deal of attention because it shows a relatively stronger oxidative power under exposure to visible light (>400 nm) [33]. Doping copper with $WO_3$ has more applications like solid state memory [34, 35], programmable metallization cell (PMC) [36], gas sensors [37] are available. The increase in efficiency for these applications and the demand of their design lead to develop the performance of the tungsten-oxide material systems.

During the last few years, many research groups focused on the preparation of innovative catalysts for bacterial inactivation. The Cu (II)/$WO_3$ nanoparticles show efficient antibacterial activity under visible light [38]. Results of paper suggest potential applications for the Cu/$WO_3$-added PTFE particulate hydrophobic composite material both indoors for antibacterial action and air deodorizing, and outdoors for prevention of contamination [39].

Ultrathin films, the thickness of which does not exceed 10 nm, have a wide a range of existing and potential applications such as: electronics (metallization in the manufacture of microcircuits), optics (high quality mirrors), energy saving (multi-layer low-emission heat-reflecting coatings MeOx / Cu / MeOx), etc. The huge potential of this kind of coatings is due to unique properties uncharacteristic for bulk materials. It is connected with an increase in the influence of film nucleation mechanisms on its final characteristics. However, the problem of controlling the properties of ultrathin films during their growth is the focus of attention of scientists engaged in surface physics already several decades.High power impulse magnetron sputtering- one of the youngest and most active developing directions of pulsed magnetron sputtering [40-42]. Further relevant prior art is disclosed in KUZMIN A. ET AL: "X-ray absorption spectroscopy of Cu-doped WO3 films for use in electrochemical metallization cell memory",JOURNAL OF NON-CRYSTALLINE SOLIDS, vol. 401, 1 October 2014 (2014-10-01), pages 87-91, XP055795234,NL ISSN: 0022-3093, DOI: 10.1016/j.jnoncrysol.2014.01.022.

## Summary of the Invention

The goal of the invention is to provide an antiviral and antibacterial coating structure, which can be used e.g. for hospital textile clothing, glass, and metal-plates antibacterial surfaces.

The set goal is achieved by providing a process for deposition of an antimicrobial multilayer coating on a substrate by reactive magnetron sputtering, comprising the following steps:(i)positioning a substrate in a vacuum chamber having two magnetrons: one and two and tungsten and cuprum sources for sputtered particles and a process gas shroud means for partially enveloping the magnetrons one and two, the substrate having a surface facing the sources;(ii)withdrawing and depleting gas from the vacuum chamber and creating process pressure below $1 \times 10^{-5}$ Torr;(iii)introducing an inert gas and oxygen to the shroud means and the vacuum chamber with $5 \times 10^{-3}$ - $30 \times 10^{-3}$ Torr said gases partial pressure;(iv) operating the magnetron one to sputter tungsten particles from the tungsten source for coating the substrate surface with a tungsten oxide layer; as soon as the desired thickness of coating on the substrate surface is reached, disactivating the magnetron one;(v)withdrawing and depleting gas from the vacuum chamber and creating process pressure below $1 \times 10^{-5}$ Torr;(vi)introducing an inert gas to the shroud means and the vacuum chamber with $1.2 \times 10^{-3}$ - $5 \times 10^{-3}$ Torr inert gas partial pressure; (vii) operating the magnetron two to sputter cuprum particles from the cuprum source for coating the tungsten oxide layer obtained at the step (iv) with a cuprum layer; as soon as the desired thickness of the cuprum layer coating on the tungsten oxide layer is reached, disactivating the magnetron two;(viii) introducing oxygen to the shroud means and the vacuum chamber with $5 \times 10^{-3}$ - $30 \times 10^{-3}$ Torr oxygen partial pressure; (ix)operating the magnetron one to sputter tungsten particles from the tungsten source for coating the cuprum layer obtained at the step (vii) by a tungsten oxide layer; as soon as the desired thickness of coating on the cuprum layer is reached, disactivating the magnetron one. According to the preferred embodiment, the oxygen flow at the steps (vi) and (viii) is spatially directed from the tungsten source to the substrate.

According to another embodiment, the process may further comprise the step of (vii') of withdrawing and depleting gas from the vacuum chamber and creating process pressure between $1 \times 10^{-5}$ and $1 \times 10^{-9}$ Torr before the step (viii) and at the step (viii) an inert gas is introduced to the shroud means and the vacuum chamber before or simultaneously with oxygen and the inert gas partial pressure is selected from $1.40 \times 10^{-8}$ - $1.74 \times 10^{-5}$ Torr.

According to yet another embodiment, the inert gas and oxygen can be introduced to the shroud means with the following gas flow rates: P(inert gas) / P($O_2$):
10-20: 30 standard cubic centimeters per minute (SCCM).

The set goal is achieved also by providing an antimicrobial multilayer coating on a substrate, wherein the multilayer coating comprises the first tungsten oxide coating layer having thickness in the range of 100-187 nm; a cuprum coating layer having thickness in the range of 19-21 nm, the cuprum coating layer being disposed on the first tungsten oxide coating layer; and the second tungsten oxide coating layer having thickness in the range of 100-120 nm and being disposed on the cuprum coating layer. The substrate can be glass, polymer, resin, Polyethylene terephthalate (PET), metal, or textile.

Brief Description of Drawings

Fig. 1 schematically shows a structure of $WO_3$/Cu/$WO_3$ multilayer films on a substrate according to one embodiment of the invention;
Fig. 2 - X-ray diffractograms of the $WO_{3-x}$/Cu/$WO_{3-x}$ (sample3) and $WO_{3-x}$:Cu (sample 4) on glass and PET substrates;
Fig. 3 - X-ray diffractograms of the $WO_{3x}$/Cu/$WO_{3-x}$ and $WO_{3-x}$:Cu samples G242, G252, PET-2, and PET-9;
Fig. 4- transmittance of the $WO_{3-x}$/Cu/$WO_{3-x}$ and $WO_{3-x}$:Cu samples with the varied deposition parameters, the coatings are further described in the Table 1;
Fig. 5- transmittance of the $WO_{3-x}$/Cu/$WO_{3-x}$ and $WO_{3-x}$:Cu samples G248, G252, and PET-7, as well as PET and glass substrates;
Fig. 6 - reflectance of the $WO_{3-x}$/Cu/$WO_{3-x}$ and $WO_{3-x}$:Cu samples with the varied deposition parameters; the coatings are further described in the Table 1;
Fig. 7 - reflectance of the $WO_{3-x}$/Cu/$WO_{3-x}$ and $WO_{3-x}$:Cu samples G248, G252, and PET-7, as well as PET and glass substrates;

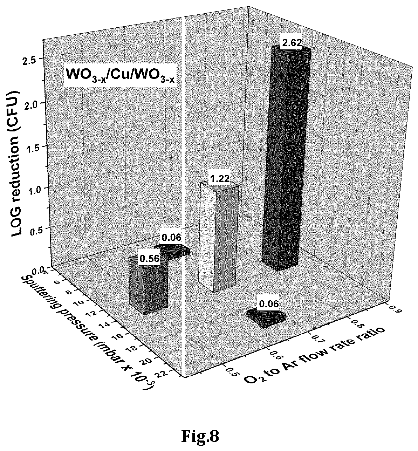

Fig. 8 -a diagram showing samples sputtered under different pressure and inert gas to oxygen proportion, having different anti-bacterial efficiency.

Detailed Description of the Invention

The proposed $WO_3$/Cu/$WO_3$ (dielectric-metal-dielectric DMD) coating structure has low electrical resistivity and high optical, in the visible range of the electromagnetic spectrum, transparency.
This new coating produced by plasma vacuum technologies act as an anti-microbial coating that merges several antibacterial and antiviral properties in one product; it prevents attachment viruses and bacteria, avoids biofilm formation, and kills the microorganisms by reactive oxygen species.
The application of high-power impulse magnetron sputtering (HiPIMS), instead of conventional DC or RF magnetron sputtering methods [43] might present an opportunity to generate such structures without the deposition of the fourth sacrificial layer. In HiPIMS, high-power pulses are applied to the magnetron target at a low duty cycle to maintain a manageable average output power [44-45].
A G500M / 2 vacuum coater (Sidrabe) and an ION'X® planar balanced magnetron (Thin Film Consulting) with a target size of 100 mm×200 mm×9 mm were used for the particular experiment. To prevent damage to the target and to be more stable than constant average current or voltage modes, constant average power was selected. The maximum output voltage and peak current of this power supply are 1000 V and 500 A respectively, so the maximum pulse power is 500 kW (max. 5 kW DC). The maximum output voltage and peak current of this power supply is 1000 V and 500 A, respectively, thus the maximum pulse power is 500 kW (5kW max. DC). The negative voltage was supplied to the magnetron cathode against a grounded anode. The discharge voltage and current were measured by a MS-500-D-TB measuring system (Melec) and recorded by a RIGOL DS1074B digital oscilloscope. The OES from the discharge was collected through the chamber window by an optical fibre probe overlooking the discharge parallel 2 cm above the target surface. The time average OES were detected by an Ocean Optics HR4000 spectrometer.
In order to be able to make subsequent comparison of the results of applying tungsten oxide in Pulsed DC mode with the results obtained in HiPIMS mode, it was decided to apply it at a power of P = 500 W in both cases, expecting that when working with HiPIMS, we will not be able to work at a power more than P = 500 W due to voltage limitation of the HiPIMS power supply. The power supply provided by the ISSP UL from MELEC was used. Its maximum voltage per pulse is 1000 V, and its maximum current is 500 A. The following operating parameters of the power supply were selected: sputtering power: 500 W; sputtering pulse duration: 100 μsec; the duration of the time interval between pulses was 14, 10, 7, and 5 msec that corresponds to the frequency of the sputtering pulses 70.9, 99.0, 140.8, 196.1 Hz. The oxygen supply to the tungsten sputtering zone does not allow the gas to be concentrated near the substrate, where, in fact, oxide is formed. The dynamic metal- oxide balance on the target as a whole reduces its sputtering rate, and hence the growth rate of the oxide coating. To overcome these shortcomings and increase oxide coating's growth rate, it is advisable to reorient the oxygen flow, directing it from the tungsten source to the substrate. For this purpose, it is possible to install an oxygen distribution injector with an outlet flow towards the substrate or to use an ion gun with oxygen to assist the deposition of the oxide. Only a change in the direction of the oxygen flow towards the substrate allows to increase oxide growth rate by 1.5 -2.0 times in the R-HiPIMS process.
Different substrates can be used for growing thin films depending on the study or analysis that will take place. In particular experiment the inventors used glass and PET (Polyethylene terephthalate), however use of other materials, such as polymer, metal and textile is possible. Influence of the main sputtering parameters (working gas type and pressure, MSS power, substrate bias potential, target etc.) on the grain size, film morphology catalytic properties should be taken into account for the effective electro catalysts synthesis.

The film's thickness was determined by a profilometer, CART VeecoDektak 150. The WOx /Cu /WOx structure was examined by an X-ray diffractometer with Cu K$\alpha$ radiation, PANalyticalXPert Pro. The film's transmittances, in the range of 200 to 1100 nm, were determined by a doublebeam spectrophotometer, Analytik Jena AG Specord 210 and Cary 7000.

Thickness Measurements.

Various thicknesses of each layer of WOx /Cu /WOx (DMD) structure had been investigated by the inventors. The characterization of the samples was done using different techniques depending on the information that was to be gained from the sample. Albeit 20 nm thickness was calibrated for the Cu layer, the thickness of the WOx thin films shows a variation between 40 and 200 nm. The measurements of the thickness of the Cu thin films were executed by the MII-4 interferometer. Diversely the thickness of the WOx thin films were determined using FILMETRICS device. In order to investigate the crystal structure of the thin films the Rigaku MiniFlex 600 benchtop X-ray diffractometer with the HyPix-400 MF 2D hybrid pixel array detector (HPAD) was used.

The samples were divided into two categories as deposited by DC magnetron sputtering and HiPIMS. Table 1 shows the main parameters of the samples studied under one experiment. Samples #4 and G252 are not according to the invention.

Table 1. Studied samples with the varied deposition parameters.

| No. | Material | Sputtering pressure (mTorr x $10^{-3}$) | O$_2$/Ar flows (sccm/sccm) | Power (W) |
|---|---|---|---|---|
| Coatings on PET deposited by DCMS | | | | |
| 1 | WO$_{3-x}$/Cu/WO$_{3-x}$ (100/20/100 nm) | 10 | 20/30 | 300 |
| | | 5 | 0/30 | 300 |
| | | 10 | 20/30 | 300 |
| 2 | WO$_{3-x}$/Cu/WO$_{3-x}$ (100/20/100 nm) | 30 | 20/30 | 300 |
| | | 5 | 0/30 | 300 |
| | | 30 | 20/30 | 300 |
| 3 | WO$_{3-x}$/Cu/WO$_{3-x}$ (100/20/100 nm) | 20 | 20/30 | 300 |
| | | 5 | 0/30 | 300 |
| | | 20 | 20/30 | 300 |
| 4 | Cu(20 nm) | 5 | 0/30 | 300 |
| Coatings on the soda-lime glass deposited by DCMS | | | | |
| G242 | WO$_{3-x}$/Cu/WO$_{3-x}$ (120/20/120 nm) | 10 | 20/30 | 300 |
| | | 5 | 0/30 | |
| | | 10 | 20/30 | |
| G244 | WO$_{3-x}$/Cu/WO$_{3-x}$ (120/20/120 nm) | 20 | 20/30 | 300 |
| | | 5 | 0/30 | |
| | | 20 | 20/30 | |
| G246 | WO$_{3-x}$/Cu/WO$_{3-x}$ (120/20/120 nm | 10 | 15/30 | 300 |
| | | 5 | 0/30 | |
| | | 10 | 15/13 | |
| G248 | WO$_{3-x}$/Cu/WO$_{3-x}$ (120/20/120 nm) | 10 | 25/30 | 300 |
| | | 5 | 0/30 | |
| | | 10 | 25/30 | |

(continued)

| Coatings on the soda-lime glass deposited by DCMS | | | | |
|---|---|---|---|---|
| G252 | WO$_{3-x}$:Cu, 5 at.% (187 nm) | 10 | 20/30 | W: 300 Cu: 10 |
| Coatings on PET deposited by DCMS | | | | |
| PET-2 | WO$_{3-x}$/Cu/WO$_{3-x}$ (200/20/200 nm) | 1.2 | 90/150 | 500 |
| | | 1.2 | 0/150 | 1000 |
| | | 1.2 | 90/150 | 500 |
| No. | Coatings deposited by HiPIMS | Sputtering pressure (mTorr x 10$^{-3}$) | O$_2$ flow (sccm) | Power (W) |
| PET-7 | WO$_{3-x}$/Cu/WO$_{3-x}$ (115/20/100 nm) | 20 | 35/150 | 500 |
| | | 1.6 | 0/150 | 1000 |
| | | 20 | 35/150 | 500 |
| PET-9 | WO$_{3-x}$/Cu/WO$_{3-x}$ (120/20/126 nm) | 5 | 95/150 | 500 |
| | | 5 | 0/150 | 1000 |
| | | 5 | 95/150 | 500 |

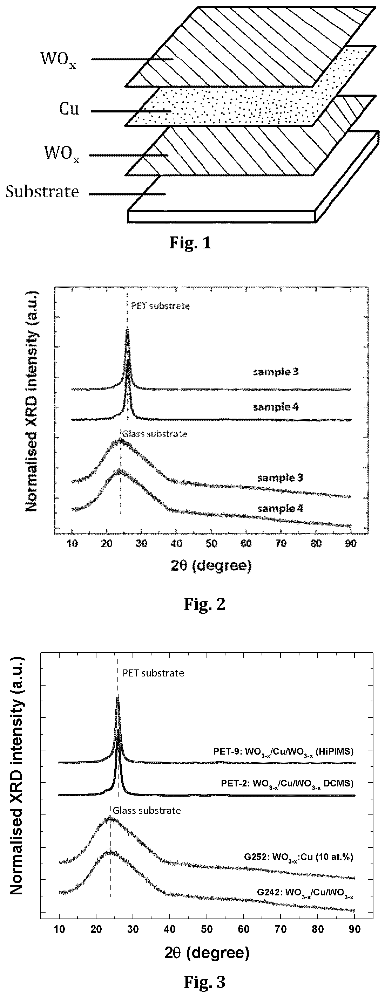

Structure WO$_3$/Cu/WO$_3$ multilayer films on a PET substrate are shown in Fig. 1.

According to the XRD results, the copper thin films tend to form in an amorphous structure. Even though there is no intentionally reactive gas flow during the growth, in DC regime, the tungstenthin film forms in oxide structure, WOx, as nanocrystal or there generates a native oxide layer on the top of the film. The peaks at 35.5, 35.9 and 41.6 (2 $\theta$) can be responsible for WO$_3$ [46, 47].

On the other hand, for the sake of the clarity, one must consider there are several stable phases in the formation of tungsten oxide such as WO$_3$, WO$_2$, W$_{24}$O$_{68}$ [48]. This diversity in the stabilization makes it hard to do an assignment of the peaks of interest. On the other hand, the thin films stay in the amorphous phase in a reactive state.

The XRD diffractograms of the selected coatings, recorded over a range for 2$\theta$ of 10°-90°, are shown in Fig. 2-3. WO$_{3-x}$/Cu/WO$_{3-x}$ andCu coatings are X-ray amorphous regardless of sputtering regime or deposition parameters. It is known that the reactively sputtered WO$_3$ films, without additional substrate heating, grow in the amorphous/nanocrystalline phase. The crystalline structure of Cu was not observed, most likely due to the low thickness ($\leq$ 20 nm). The XRD features detected at around 26° and 24° correspond to PET and the glass substrates, respectively.

Taking into the account of Copper thin film, it is also recognizable there exist as an additive to the shoulder which can result from the oxidization of Cu as Cu$_2$O or CuO [49]. This phenomenon can happen either during the deposition or after (Creation of native oxide on the surface of the thin film) the growth. PET is a widely used material both in research and in the industry due to the fact that, it has high optical transparency and high flexibility.

For the optical characterizations in the UV-VIS and NIR of the deposited thin films the Cary 7000 Spectrophotometer with the wavelength accuracy UV-VIS: +/- 0.08 nm, NIR: +/- 0.04 nm was used. In this experiment, it is aimed at constructing a relationship between the deposition parameters and optical properties (transmission, reflection and absorption) of the samples of interest. For an ideal transparent conducting oxide (TCO) the transparency in the visible range must be higher than the 85% [50]. The inventors have investigated dielectric/metal/dielectric, WOx /Cu/WOx structure. Depending on the absorbed wavelength of the electromagnetic wave, there happens different phenomena.

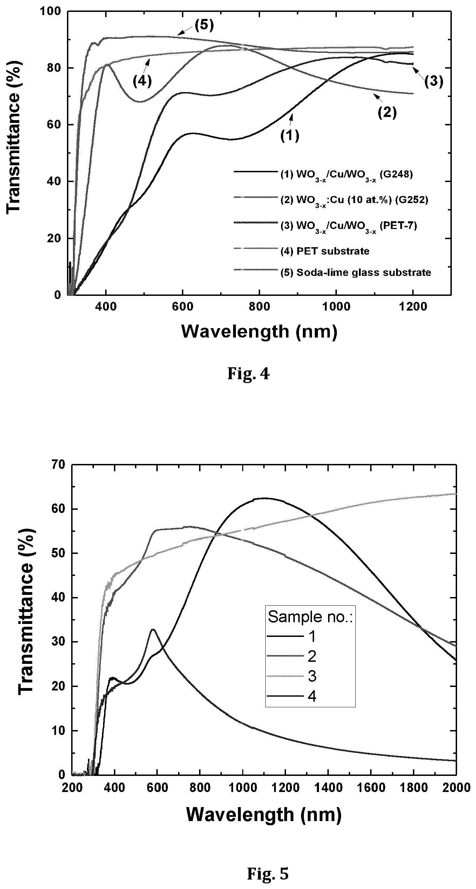

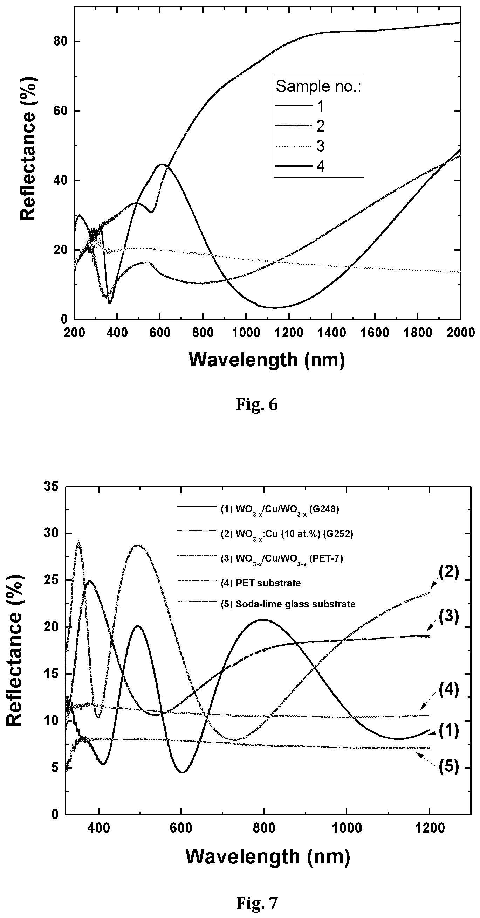

The transmittance spectrum (Vis : 300 - 1000 nm) can be separated into three main section the higher wavelength zone is the region in which the light is affected by the lattice vibration, the middle energy region responsible for the transmission presentence of the light through the matter of interest. The higher frequency region, on the other hand, gives information about the electronic structure, i.e. electron transfer from the valence band to the conduction band. The transmittance measurements were done by Cary 7000 show harmony with the measurements done in situ. In Dc mode sputtering the metal W and Cu thin films are characterized as well as oxide mode of tungsten and WOx/Cu and WOx/Cu/WOx. Figure 4-5 shows the transmittance spectrum of the thin films deposited by DC magnetron sputtering and Fig. 6-7 shows reflectance spectrum of the thin films deposited by HiPIMS.

At lower energy regions the characteristic PET absorption dominates the metallic tungsten and WO$_x$/Cu. In the visible region, the spectrum shows the wave behavior that corresponds to the strong interference, overlapping of the photons reflected from either side of the thin film or/and from the interface of the films. For metallic tungsten thin film, there is no significant interference or characteristic absorption and it shows a perfect metallic transmittance spectrum. On the other hand, the Cu thin film has a relatively higher transmission and interference in the visible range. This interference can occur not only due to the fact that the reflection of the light from the surfaces but also it may be affected by the native oxide layer formed of the on surface (thin film - native oxide interface). The film shows a soft interference effect at the low energy t and relatively high transmittance in the visible range. The transmission presentence is still far beyond than the demanded parameters. In the transmittance spectrum of the high-power impulse regime, the film deposited with a higher 02 flow rate (150 sccm) show higher transparency in the visible range compared with 95 and 45 sccm. On the other hand, the film deposited by 35 sccm has the highest value in the same range.

The transmittance measurements for the $WO_x$ /Cu /$WO_x$ are higher than the pure copper thin film. Depending on the optical properties only 10 samples (5 samples deposited by means of HiPIMS, 5 samples deposited by DC Magnetron Sputtering) were selected for antibacterial, anti-fungal and antiviral properties testing.

Antibacterial, antiviral activity.

Antibacterial activity of the proposed coating structure tested on Gram negative bacteria *Eschericheacoli* and Gram positive bacteria *Staphylococcus aureus.*

Two bacteria cultures were used in this study, i.e., *Escherichea coli,* and *Staphylococcus aureus.* Cell suspension was prepared from 12h cultures (220 rpm, at 37°C for *E.coliand S.aureus*)with the final cell concentration $10^7$ CFU/mL.

Cultivation media.

Bacterial cultures of *E.coliand S. aureus* were cultivated in Tryptic soy broth - TSB, respectively. Composition of TSB broth was as follows, casein (pancreatic digest) 17 g/L; soya peptone (papaic digest) 3 g/L; sodium chloride 5 g/L; dipotassium phosphate 2.5 g/L; dextrose 2.5 g/L

Antimicrobial surface testing.

The test piece 10x10 mm was immersed in ethanol and dried completely. test pieces were placed in sterile 12 wellplate cells, 20 μL suspension was placed on the testing surface and covered by a sterile parafilm 7x7 mm (parafilm was previously immersed in ethanol, dried and exposed to UV for 30 min). 12 welltes with test pieces were closed and left at 23 °C for 120 minutes. All variants were prepared in triplicate. Afterwards, 1800μL of sterile TSBbroth was added to the 12 well plate cells with samples and shaked for 10 minutes (220 rpm, RT) Cell suspension (20 μL) from the 12 well plate was immediately transferred to the microplate with 180 μL of TSB broth for preparing the decimal dilutions. Samples were plated by a microdilution droplet method on the respective (as cultures were previously cultivated) solidified media. The number of colony forming units (CFU) was counted after 24 h incubation at 30 °C. The conditions of test effectiveness were judged by preparing an additional sample with the untreated test piece and test culture, which was immediately plated without incubation.

The value of antimicrobial activity (LOG reduction) was calculated, according to the following equation:

$$R = [\log (B/A)] - \log (B/C)], \text{ where} \qquad (1)$$

R: value of antimicrobial activity;
A: average of the CFU number immediately after inoculation on the untreated test piece;
B: average of the CFU number on the untreated test piece after incubation;
C: average of the CFU number on the antimicrobial test piece after incubation.

Table2. Log Reduction for microbial cultures and bacteriophage after 120 min exposure to the surface of antimicrobial samples. Sample description is in Table 1.

| No. | E.coli | S.aureus | MS2 bacteriophage |
|---|---|---|---|
| 1 | >4 | >4 | >6 |
| 2<br>3 | 1.3<br>3 | >4<br>>4 | 4<br>>6 |
| 4 | >4 | >4 | >6 |
| G239 | 0.06 | | |
| G242 | 1.22 | | |

(continued)

| No. | E.coli | S.aureus | MS2 bacteriophage |
|---|---|---|---|
| G244 | 0.06 | | |
| G246 | 0.58 | | |
| G248 | 2.82 | | |

The PET sample No. 2 showed the lowest antimicrobial activity towards three cultures under tested conditions. The culture *S. aureus* was the most sensitive to the tested coatings, as compared to *E.coli.*

M2 bacteriophage virus validation of anti-viral properties of the proposed coating structure. MS2 bacteriophage (*Emesviruszinderi*) icosahedral, +strand RNS viruss that infects E.colibacteria. MS2 is widely used for anti-viral effects evaluation due to low cost of target cell *E.coli* culture maintenance process relative simplicity. MS2 bacteriophage is non-pathogenic for humans and all the testing can be performed in the first biosafety level laboratory environment.

In order to assess the virucidal properties of the coated films the MS2 bacteriophage virus was incubated on the surface of the films, washed out, and used for cell infection.

Briefly, 10 mkl of the virus containing solution, with viral particle titre 10e7, were incubated on the surface of the films for 2 h at RT. Then the film was soaked with 1 ml TSB medium. A day before, $1 \times 10^7$ *E.coli* XL1-Blue bacteria suspension was prepared, from testing samples surfaces washed MS2 added to XL1-Blue suspension was in 96-well plate cells, incubated for 6 h for bacteria growth evaluation by measuring optical density. Lover rate of optical density growth corresponds to higher MS2 bacteriophage activity.

The proposed coating acts as an anti-microbial coating that merges several anti-bacterial and anti-viral properties in one product; it prevents attachment viruses and bacteria, avoids biofilm formation, and kills the microorganisms by radical oxygen species. Also, the samples were demonstrated high (up to 70 %) optical transmittance. Mutual reinforcement of the copper and tungsten oxide layers used showed an increase in antimicrobial activity.

Reduction of cultivable *Escherichia coli* counts depending on the sputtering pressure and the $O_2$-to-Ar gas flow ratio for the upper layer of $WO_{3-x}$/Cu/$WO_{3-x}$ samples (G239, G242, G244, G246, and G248) imaged in figure 5. clearly shows that the antibacterial activity against *E. coli* is highly dependent on the deposition parameters of $WO_{3-x}$ upper layer, such as the sputtering pressure and the $O_2$-to-Argas flow ratio. The latter can be used to control the composition of the film. In this case, the increase in antibacterial activity (from 0.56 to 2.62 log reduction values) with the $O_2$-to-Argas flow ratio (from 0.50 to 0.83 at sputtering pressure of $13.3 \times 10^{-3}$ mbar) for the $WO_{3-x}$/Cu/$WO_{3-x}$ samples (G242, G246, and G248) indicates that the stoichiometric composition is more efficient than sub-stoichiometric.

**References**

1. Sun, X., Zhang, S., Li, H., & Bandara, N. (2020). Anti-Adhesive Coatings. Green Adhesives, 1-23.doi:10.1002/9781119655053.ch1.
2. Akter, M.; Sikder, M. T.; Rahman, M. M.; Ullah, A. A.; Hossain, K. F. B.; Banik, S.; Hosokawa, T.; Saito, T.; Kurasaki, M. A systematic review on silver nanoparticles- Applied Materials & Interfaces. doi:10.1021/acsami.0c17550.
4. Kittler, S.; Greulich, C.; Diendorf, J.; Köller, M.; Epple, M. Toxicity of silver nanoparticles increases during storage because of slow dissolution under release of silver ions. Chem. Mater. 2010, 22, 4548-4554.

induced cytotoxicity: Physicochemical properties and perspectives. J. Adv. Res. 2018, 9, 1-16.
3. Holden, J. A., Reynolds, E. C., Heath, D. E., O'Brien-Simpson, N. M., & O'Connor, A. J. (2020). Multifunctional Antimicrobial Polypeptide-Selenium Nanoparticles Combat Drug-Resistant Bacteria. ACS Hospital Acquired Bacterial and Viral Pathogens. Nanomaterials 2020, 10, 1017.
17. Warsi, A.-Z.; Aziz, F.; Zulfiqar, S.; Haider, S.; Shakir, I.; Agboola, P.O. Synthesis, Characterization, Photocatalysis, and Antibacterial Study of WO3, MXene and WO3/MXene Nanocomposite. Nanomaterials 2022, 12, 713.

(continued)

5. Kim, S.; Choi, J. E.; Choi, J.; Chung, K.-H.; Park, K.; Yi, J.; Ryu, D.-Y. Oxidative stress-dependent toxicity of silver nanoparticles in human hepatoma cells. Toxicol. In Vitro 2009, 23, 1076-1084.

6. US 8080490 B2.
7. EP1676582 B1.
8. EP 3082415 B1.
9. EP 2988794 B1.
10. JP 5812488 B2.
11. US 9439439 B2.
12. EP 2 255 878 B1.
13. US 10327445 B2.
14. US 10327445 B2.
15. Guangxin Duan, Lu Chen, Zhifeng Jing, Phil De Luna, Ling Wen, Leili Zhang, Lin Zhao, Jiaying Xu, Zhen Li, Zaixing Yang, and Ruhong Zhou, Robust Antibacterial Activity of Tungsten Oxide (WO3-x) Nanodots. Chem. Res. Toxicol. 2019, 32, 1357-1366.

16. Rupy Kaur Matharu, Lena Ciric, GuogangRen and Mohan Edirisingh. Comparative Study of the Antimicrobial Ettects of Tungsten Nanoparticles and Tungsten Nanocomposite Fibres on

28. S. H. Lee et al., Gasochromic mechanism in a-WO3 thin films based on Raman spectroscopic studies. J. Appl. Phys. 88 (2000) 3076-3078.

29. C. O. Avellaneda, L. O. S. Bulhoes, Intercalation in WO3 and WO3: Li films. Solid State Ionics 165 (2003) 59-64.

30. G. Zhang, C. Xie, A novel method in the gas identification by using WO3 gas sensor based on the temperature-programmed technique. Sensors and Actuators B: Chemical206(2015) 220-229.

31. W. Shi, X. Guo, C. Cui, K. Jiang, Z. Li, L. Qu, Ji-Chao Wang, Controllable synthesis of Cu2O decorated WO3 nanosheets with dominant (001) facets for photocatalytic CO2 reduction under visible-light irradiation, Applied Catalysis B: Environmental 243 (2019) 236-242.

32. M. Feng et al., Strong photoluminescence of nanostructured crystalline tungsten oxide thin films. Appl. Phys. Lett. 86 (2005) 141901-141903

33. Y. Yao, K. Yamauchi, G. Yamauchi, T. Ochiai, T. Murakami, Y. Kubota. Synergistic Antibacterial Performance of a Cu/WO3-Added PTFE Particulate Superhydrophobic Composite under Visible-Light Exposur, Journal of Biomaterials and Nanobio technology 3 (2012) 421-430.

34. M.N. Kozicki, C. Gopalan, M. Balakrishnan, M. Park, and M. Mitkova, "Non-volatile memory based on solid electrolytes," Proceedings of the 2004 Non-Volatile

18. CA2134217C.
19. 19. EP 2 430 922 B1.
20. US8158137B2.
21. US7704903B2.
22. RU2633536 C1
23. G. Granqvist, Electrochromic tungsten oxide films: review of progress 1993-1998. Sol. Energy Mater. Sol. Cells 60(2000) 201-262.

24. Zheng, J. Z. Ou, M.S. Strano, R.B. Kaner, A. Mitchell and K. Kalantar-zadeh. Nanostructured tungsten oxide-properties, synthesis and applications Adv. Funct. Mater. (2011) 212175-96.

25. Shen, L. Zhang, J. Ren, J. Wang, H. Yao and Z. Li. Highly enhanced acetone sensing performance of porous C-doped WO3hollowspheres by carbon spheres as templates Sensors Actuators B: Chem. (2017) 239597-607.

26. M. Gillet, K. Masek, E. Gillet, Structure of tungsten oxide nanoclusters. Surf. Sci. 566- 568 (2004) 383-389.

27. G. Granqvist, Handbook of electrochromic materials (Elsevier, Amsterdam, 1995)

Memory Technology Symposium (NVMTS), 10-17 (2004).

35. Gopalan, M. N. Kozicki, S. Bhagat, S. C. PuthenThermadam, T. L. Alford, M. Mitkova. Structure of copper-doped tungsten oxide films for solid-state memory, Journal of Non-Crystalline Solids 353 (2007) 1844-1848.

36. M. B. Balaban, N. Chamele, S. S. Swain, Y. Gonzalez-Velo, M. N. Kozicki, Fabrication and characterization of Cu2O/Cu-WO3 bilayers for lateral programmable metallization cells,AppliedSurface Science527 (2020)146899.

37. B. Sonawane, D. R. Patil, L. A. Patil, CuO-Modified WO3 Sensor for the Detection of a ppm Level H2S Gas at Room Temperature, Sensors & Transducers Journal 93 (2008) 82-91.

38. B. M. Alshabander, Copper (II)-doped WO3 nanoparticles with visible light photocatalytic antibacterial activity against gram-positive and gram-negative bacteria, InorganicandNano-Metal-Chemistry, 1-5(2020).

39. Yamauchi, T. Ochiai, G. Yamauchi. The Synergistic Antibacterial Performance of a Cu/WO3-Added PTFE Particulate Superhydrophobic Composite Material. Journal of Biomaterials and Nanobiotechnology,6 (2015)1-7.

40. M. Zubkins, H. Arslan, L. Bikse, et al., High power impulse magnetron sputtering of Zn/Al target in an Ar and Ar/O2 atmosphere: The study of sputtering

(continued)

process and AZO films, Surface & Coatings Technology 369 (2019) 156-164.

41. Agnarsson, F.Magnus, T.K. Tryggvason, A.S. Ingasona, K. Leosson, S. Olafsson, J.T. Gudmundsson. Rutile TiO2 thin films grown by reactive high power impulse magnetron sputtering. Thin Solid Films (2013).

42. Hamed Najafi-Ashtiani, Behnam Akhavan, Fengjuan Jing, and Marcela M. Bilek. Transparent Conductive Dielectric-Metal-Dielectric Structures for Electrochromic Applications Fabricated by High-Power Impulse Magnetron Sputtering ACS Appl. Mater. Interfaces.

43. Y. Yin, C. Lan, H. Guo, C. Li, Reactive Sputter Deposition of WO3/Ag/WO3 Film for Indium Tin Oxide (ITO)-Free Electrochromic Devices. ACS Appl. Mater. Interfaces, 8 (2016) 3861-3867

44. A. Anders, A review comparing cathodic arcs and high power impulse magnetron sputtering (HiPIMS). Surf. Coat. Technol., 257 (2014) 308-325.

45. R. Ganesan, B. Akhavan, X. Dong, D.R. McKenzie, M.M.M. Bilek. External Magnetic Field Increases Both Plasma Generation and Deposition Rate in HiPIMS; Surface & Coatings Technology, (2018) 671-679.

46. Huang, M. Mazhar. Ali Kalyar, R. F. Webster, D. Cherns and M. N. R. Ashfold, Tungsten oxide nanorod growth by pulsed laser deposition: influence of substrate and process conditions.Nanoscale 6(22) (2014) 13586-13597.

47. Widenkvist, R. A. Quinlan, B. C. Holloway, H. Grennberg and U. Jansson. Synthesis of nanostructured tungsten oxide thin films. Crystal Growth and Design, 8 (10) (2008) 3750-3753.

48. S.-J. Lin, J. Cheng, C. -Fu Zhang, B. in Wang, Y.-F. Zhang and X. Huang. The reactivity of stoichiometric tungsten oxide clusters towards carbon monoxide: the effects of cluster sizes and charge states. Physical Chemistry Chemical Physics, 17 (17) (2015) 11499-11508.

49. X. Zhang, M. Huang, F. Li, Z. Q. Wen Controlled synthesis of hierarchical CuO nanostructures for electrochemical capacitor electrodes. Int. J. Electrochem. Sci., 8 (2013) 8645-8661.

50. H. Arslan, Indium tin oxide (ITO) coating on cylindrical surfaces: Electrical and structural characterization. 2015, Izmir Institute of Technology.

## Claims

1. A process for deposition of an antimicrobial multilayer coating on a substrate by reactive magnetron sputtering, comprising the following steps:

    (i) positioning a substrate in a vacuum chamber having two magnetrons: one and two containing tungsten and cuprum sources for sputtered particles and a process gas shroud means for enveloping the magnetrons one and two, the substrate having a surface facing the sources;
    (ii) withdrawing and depleting gas from the vacuum chamber and creating process pressure below $1 \times 10^{-5}$ Torr;
    (iii) introducing an inert gas and oxygen to the shroud means and the vacuum chamber with $5 \times 10^{-3}$ - $30 \times 10^{-3}$ Torr said gases partial pressure;
    (iv) operating the magnetron one to sputter tungsten particles from the tungsten source for coating the substrate surface with a tungsten oxide layer; as soon as the desired thickness of coating on the substrate surface is reached, disactivating the magnetron one;
    (v) withdrawing and depleting gas from the vacuum chamber and creating process pressure below $1 \times 10^{-5}$ Torr;
    (vi) introducing an inert gas to the shroud means and the vacuum chamber with $1.2 \times 10^{-3}$ - $5 \times 10^{-3}$ Torr inert gas partial pressure;
    (vii) operating the magnetron two to sputter cuprum particles from the cuprum source for coating the tungsten oxide layer obtained at the step (iv) with a cuprum layer; as soon as the desired thickness of the cuprum layer coating on the tungsten oxide layer is reached, disactivating the magnetron two;
    (viii) introducing oxygen to the shroud means and the vacuum chamber with $5 \times 10^{-3}$ - $30 \times 10^{-3}$ Torr oxygen partial pressure;
    (ix) operating the magnetron one to sputter tungsten particles from the tungsten source for coating the cuprum layer obtained at the step (vii) by a tungsten oxide layer; as soon as the desired thickness of coating on the cuprum layer is reached, disactivating the magnetron one.

2. The process according to claim 1, wherein the oxygen flow at the steps (vi) and (viii) is spatially directed from the tungsten source to the substrate.

**3.** The process according to claim 1 or 2, wherein the process further comprises the step of (vii') of withdrawing and depleting gas from the vacuum chamber and creating process pressure between $1\times10^{-5}$ and $1\times10^{-9}$ Torr before the step (viii) and at the step (viii) an inert gas is introduced to the shroud means and the vacuum chamber before or simultaneously with oxygen and the inert gas partial pressure is selected from $1.40\times10^{-8}$ - $1.74\times10^{-5}$ Torr.

**4.** The process according to any preceding claims, wherein the inert gas and oxygen are introduced to the vacuum chamber with the following gas flow rates: P (inert gas) / P ($O_2$): 10-20: 30 SCCM.

**5.** An antimicrobial multilayer coating on a substrate obtained by the process of claims 1-4, wherein the multilayer coating comprises the first tungsten oxide coating layer having thickness in the range of 100-187 nm; a cuprum coating layer having thickness in the range of 19-21 nm, the cuprum coating layer being disposed on the first tungsten oxide coating layer; and the second tungsten oxide coating layer having thickness in the range of 100-120 nm and being disposed on the cuprum coating layer.

**6.** The antimicrobial multilayer coating on a substrate according to claim 5, wherein the substrate is selected from the group consisting of glass, polymer, resin, metal, and textile.

**7.** The antimicrobial multilayer coating on a substrate according to claim 5, wherein the substrate is a Polyethylene terephthalate (PET).

## Patentansprüche

**1.** Verfahren zum Aufbringen einer antimikrobiellen Mehrschichtbeschichtung auf ein Substrat durch reaktives Magnetron-Sputtern, das die folgenden Schritte umfasst:

(i) Positionieren eines Substrats in einer Vakuumkammer mit zwei Magnetrons: eins und zwei, die Wolfram- und Kupferquellen für gesputterte Partikel und eine Prozessgasummantelung zum Umhüllen der Magnetrons eins und zwei enthalten, wobei das Substrat eine den Quellen zugewandte Oberfläche aufweist;

(ii) Abziehen und Abbau von Gas aus der Vakuumkammer und Erzeugung eines Prozessdrucks unter $1\times10^{-5}$ Torr;

(iii) Einleiten eines Inertgases und Sauerstoff in die Hüllvorrichtung und die Vakuumkammer mit einem Partialdruck von $5\times10^{-3}$ - $30\times10^{-3}$ Torr der genannten Gase;

(iv) Betreiben von Magnetron eins, um Wolframpartikel aus der Wolframquelle zu sputtern, um die Substratoberfläche mit einer Wolframoxidschicht zu versehen. Sobald die gewünschte Dicke der Lage auf der Substratoberfläche erreicht ist, Deaktivieren von Magnetron eins;

(v) Abziehen und Abbau von Gas aus der Vakuumkammer und Erzeugung eines Prozessdrucks unter $1\times10^{-5}$ Torr;

(vi) Einleiten eines Inertgases in die Hüllvorrichtung und die Vakuumkammer mit einem Inertgas-Teildruck von $1,2\times10^{-3}$ - $5\times10^{-3}$ Torr;

(vii) Betreiben von Magnetron zwei, um Kupferpartikel aus der Kupferquelle zu sputtern, um die in Schritt (iv) erhaltene Wolframoxidschicht mit einer Kupferschicht zu versehen. Sobald die gewünschte Dicke der Kupferlage auf der Wolframoxidschicht erreicht ist, Deaktivieren von Magnetron zwei;

(viii) Einleiten eines Inertgases in die Hüllvorrichtung und die Vakuumkammer mit einem Inertgas-Teildruck von $5\times10^{-3}$ - $30\times10^{-3}$ Torr;

(ix) Betreiben von Magnetron eins, um Wolframpartikel aus der Wolframquelle zu sputtern, um die in Schritt (vii) erhaltene Kupferschicht mit einer Wolframoxidschicht zu versehen; sobald die gewünschte Dicke der Lage auf der Kupferschicht erreicht ist, Deaktivieren von Magnetron 1.

**2.** Verfahren gemäß Patentanspruch 1, wobei der Sauerstoffstrom in den Schritten (vi) und (viii) räumlich von der Wolframquelle zum Substrat hin gerichtet ist.

**3.** Verfahren gemäß Patentanspruch 1 oder 2, wobei das Verfahren ferner den Schritt (vii') umfasst, bei dem Gas aus der Vakuumkammer abgezogen und abgebaut wird und vor dem Schritt (viii) und bei Schritt (viii) ein Inertgas vor oder gleichzeitig mit Sauerstoff in die Hüllvorrichtung und die Vakuumkammer eingeleitet wird und der Teildruck des Inertgases zwischen $1,40\times10^{-8}$ und $1,74\times10^{-5}$ Torr gewählt wird.

**4.** Verfahren nach einem der vorstehenden Patentansprüche, wobei das Inertgas und der Sauerstoff mit den folgenden Gasdurchflussraten in die Vakuumkammer eingeleitet werden: P (Inertgas) / P (02): 10-20:30 SCCM.

**5.** Eine antimikrobielle Mehrschichtbeschichtung auf einem Substrat, erhalten durch das Verfahren gemäß den Patentansprüchen 1 bis 4, wobei die Mehrschichtbeschichtung aus den folgenden Komponenten besteht: die erste Wolframoxid-Beschichtungslage mit einer Dicke im Bereich von 100 bis 187 nm; eine Kupferbeschichtungslage mit einer Dicke im Bereich von 19 bis 21 nm, wobei die Kupferbeschichtungslage auf der ersten Wolframoxidbeschichtungslage angebracht wird; eine zweite Wolframoxidbeschichtungslage wird mit einer Dicke im Bereich von 100 bis 120 nm, die auf der Kupferbeschichtungslage angebracht.

**6.** Die antimikrobielle Mehrschichtbeschichtung auf einem Substrat gemäß Patentanspruch 5, wobei das Substrat aus der Gruppe ausgewählt ist, die aus Glas, Polymer, Harz, Metall und Textil besteht.

**7.** Die antimikrobielle Mehrschichtbeschichtung auf einem Substrat gemäß Patentanspruch 5, wobei das Substrat ein Polyethylenterephthalat ist (PET).

## Revendications

**1.** Procédé destiné au dépôt d'un revêtement multicouche antimicrobien sur un substrat par pulvérisation magnétron réactive, comprenant les étapes suivantes :

(i) positionnement d'un substrat dans une chambre à vide ayant deux magnétrons : numéros un et deux, contenant des sources de tungstène et de cuivre pour des particules pulvérisées et un moyen d'enveloppe de gaz de traitement permettant d'envelopper les magnétrons un et deux, le substrat ayant une surface orientée vers les sources ;
(ii) retrait et épuisement du gaz de la chambre à vide et création d'une pression de procédé inférieure à $1 \times 10^{-5}$ Torr ;
(iii) introduction d'un gaz inerte et d'oxygène dans le moyen d'enveloppe et la chambre à vide avec une pression partielle desdits gaz de $5 \times 10^{-3}$ à $30 \times 10^{-3}$ Torr ;
(iv) fonctionnement du magnétron un pour pulvériser des particules de tungstène à partir de la source de tungstène pour un revêtement de la surface de substrat avec une couche d'oxyde de tungstène ; dès que l'épaisseur souhaitée de revêtement sur la surface de substrat est atteinte, désactivation du magnétron un ;
(v) retrait et épuisement du gaz de la chambre à vide et création d'une pression de procédé inférieure à $1 \times 10^{-5}$ Torr ;
(vi) introduction d'un gaz inerte dans le moyen d'enveloppe et la chambre à vide avec une pression partielle de gaz inerte de $1,2 \times 10^{-3}$ à $5 \times 10^{-3}$ Torr ;
(vii) fonctionnement du magnétron deux pour pulvériser des particules de cuivre à partir de la couche de cuivre pour un revêtement de la couche d'oxyde de tungstène obtenue à l'étape (iv) avec une couche de cuivre ; dès que l'épaisseur souhaitée du revêtement de couche de cuivre sur la couche d'oxyde de tungstène est atteinte, désactivation du magnétron deux ;
(viii) introduction d'oxygène dans le moyen d'enveloppe et la chambre à vide avec une pression partielle en oxygène de $5 \times 10^{-3}$ à $30 \times 10^{-3}$ Torr ;
(ix) fonctionnement du magnétron un pour pulvériser des particules de tungstène à partir de la source de tungstène pour un revêtement de la couche de cuivre obtenue à l'étape (vii) par une couche d'oxyde de tungstène ; dès que l'épaisseur souhaitée de revêtement sur la couche de cuivre est atteinte, désactivation du magnétron un.

**2.** Procédé selon la revendication 1, dans lequel l'écoulement d'oxygène aux étapes (vi) et (viii) est spatialement dirigé de la source de tungstène vers le substrat.

**3.** Procédé selon la revendication 1 ou 2, dans lequel le procédé comprend en outre l'étape (vii') de retrait et épuisement du gaz de la chambre à vide et de création d'une pression de procédé entre $1 \times 10^{-5}$ et $1 \times 10^{-9}$ Torr avant l'étape (viii) et à l'étape (viii) un gaz inerte est introduit dans le moyen d'enveloppe et la chambre à vide avant ou en même temps que l'oxygène et la pression partielle en gaz inerte est choisie de $1,40 \times 10^{-8}$ à $1,74 \times 10^{-5}$ Torr.

**4.** Procédé selon l'une quelconque des revendications précédentes, dans lequel le gaz inerte et l'oxygène sont introduits dans la chambre à vide avec les débits d'écoulement de gaz suivants : P (gaz inerte) / P (02) : 10 à 20:30 $cm^3$ std/min.

**5.** Revêtement multicouche antimicrobien sur un substrat obtenu par le procédé selon les revendications 1 à 4, dans lequel le revêtement multicouche comprend la première couche de revêtement d'oxyde de tungstène ayant une épaisseur dans la plage de 100 à 187 nm ; une couche de revêtement de cuivre ayant une épaisseur dans la plage de 19 à 21 nm, la couche de revêtement de cuivre étant disposée sur la première couche de revêtement d'oxyde de tungstène ; et la seconde couche de revêtement d'oxyde de tungstène ayant une épaisseur dans la plage de 100 à 120 nm et étant disposée sur la couche de revêtement de cuivre.

**6.** Revêtement multicouche antimicrobien sur un substrat selon la revendication 5, dans lequel le substrat est choisi dans le groupe constitué de verre, polymère, résine, métal et textile.

**7.** Revêtement multicouche antimicrobien sur un substrat selon la revendication 5, dans lequel le substrat est un téréphtalate de polyéthylène (PET).

**Fig. 1**

**Fig. 2**

**Fig. 3**

Fig. 4

Fig. 5

**Fig. 6**

**Fig. 7**

Fig.8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- CA 2134217 C
- EP 2430922 B1
- US 8158137 B2
- US 7704903 B2
- RU 2633536 C1
- US 8080490 B2
- EP 1676582 B1
- EP 3082415 B1
- EP 2988794 B1
- JP 5812488 B
- US 9439439 B2
- EP 2255878 B1
- US 10327445 B2

### Non-patent literature cited in the description

- **KUZMIN A. et al.** X-ray absorption spectroscopy of Cu-doped WO3 films for use in electrochemical metallization cell memory. *JOURNAL OF NON-CRYSTALLINE SOLIDS*, 01 October 2014, vol. 401, ISSN 0022-3093, 87-91
- **SUN, X.** ; **ZHANG, S.** ; **LI, H.** ; **BANDARA, N.** Anti-Adhesive Coatings.. *Green Adhesives*, 2020, 1-23
- induced cytotoxicity: Physicochemical properties and perspectives. *J. Adv. Res.*, 2018, vol. 9, 1-16
- **HOLDEN, J. A.** ; **REYNOLDS, E. C.** ; **HEATH, D. E.** ; **O'BRIEN-SIMPSON, N. M.** ; **O'CONNOR, A. J.** Multifunctional Antimicrobial Polypeptide-Selenium Nanoparticles Combat Drug-Resistant Bacteria.. *ACS*, 2020
- **AKTER, M.; SIKDER, M. T.; RAHMAN, M. M.; ULLAH, A. A.; HOSSAIN, K. F. B.; BANIK,S.; HOSOKAWA, T.; SAITO, T.; KURASAKI, M.** A systematic review on silver nanoparticles. *Applied Materials & Interfaces*
- Hospital Acquired Bacterial and Viral Pathogens. *Nanomaterials*, 2020, vol. 10, 1017
- **KITTLER, S.** ; **GREULICH, C.** ; **DIENDORF, J.** ; **KÖLLER, M.** ; **EPPLE, M.** Toxicity of silver nanoparticles increases during storage because of slow dissolution under release of silver ions.. *Chem. Mater.*, 2010, vol. 22, 4548-4554
- **WARSI, A.-Z.** ; **AZIZ, F.** ; **ZULFIQAR, S.** ; **HAIDER, S.** ; **SHAKIR, I.** ; **AGBOOLA, P.O.** Synthesis, Characterization, Photocatalysis, and Antibacterial Study of WO3, MXene and WO3/MXene Nanocomposite.. *Nanomaterials*, 2022, vol. 12, 713
- **KIM, S.** ; **CHOI, J. E.** ; **CHOI, J.** ; **CHUNG, K.-H.** ; **PARK, K.** ; **YI, J.** ; **RYU, D.-Y.** Oxidative stress-dependent toxicity of silver nanoparticles in human hepatoma cells.. *Toxicol. In Vitro*, 2009, vol. 23, 1076-1084
- **G. GRANQVIST**. Electrochromic tungsten oxide films: review of progress 1993-1998. *Sol. Energy Mater. Sol. Cells*, 2000, vol. 60, 201-262
- **ZHENG, J.** ; **Z. OU** ; **M.S. STRANO** ; **R.B. KANER** ; **A. MITCHELL** ; **K. KALANTAR-ZADEH**. Nanostructured tungsten oxide-properties, synthesis and applications. *Adv. Funct. Mater.*, 2011, 212175-96
- **SHEN** ; **L. ZHANG** ; **J. REN** ; **J. WANG** ; **H. YAO** ; **Z. LI**. Highly enhanced acetone sensing performance of porous C-doped WO3hollowspheres by carbon spheres as templates. *Sensors Actuators B: Chem.*, 2017, 239597-607
- **GUANGXIN DUAN** ; **LU CHEN** ; **ZHIFENG JING** ; **PHIL DE LUNA** ; **LING WEN** ; **LEILI ZHANG** ; **LIN ZHAO** ; **JIAYING XU** ; **ZHEN LI** ; **ZAIXING YANG**. Robust Antibacterial Activity of Tungsten Oxide (WO3-x) Nanodots.. *Chem. Res. Toxicol.*, 2019, vol. 32, 1357-1366
- **M. GILLET** ; **K. MASEK** ; **E. GILLET**. Structure of tungsten oxide nanoclusters.. *Surf. Sci.*, 2004, vol. 566- 568, 383-389
- **RUPY KAUR MATHARU** ; **LENA CIRIC** ; **GUO-GANGREN** ; **MOHAN EDIRISINGH**. *Comparative Study of the Antimicrobial Effects of Tungsten Nanoparticles and Tungsten Nanocomposite Fibres on*
- **G. GRANQVIST**. Handbook of electrochromic materials. Elsevier, 1995
- **S. H. LEE et al.** Gasochromic mechanism in a-WO3 thin films based on Raman spectroscopic studies.. *J. Appl. Phys.*, 2000, vol. 88, 3076-3078
- *Memory Technology Symposium (NVMTS)*, 2004, 10-17

- **GOPALAN** ; **M. N. KOZICKI** ; **S. BHAGAT** ; **S. C. PUTHENTHERMADAM** ; **T. L. ALFORD** ; **M. MITKOVA**. Structure of copper-doped tungsten oxide films for solid-state memory. *Journal of Non-Crystalline Solids*, 2007, vol. 353, 1844-1848
- **C. O. AVELLANEDA** ; **L. O. S. BULHOES**. Intercalation in WO3 and WO3: Li films. *Solid State Ionics*, 2003, vol. 165, 59-64
- **G. ZHANG** ; **C. XIE**. A novel method in the gas identification by using WO3 gas sensor based on the temperature-programmed technique.. *Sensors and Actuators B: Chemical*, 2015, vol. 206, 220-229
- **M. B. BALABAN** ; **N. CHAMELE** ; **S. S. SWAIN** ; **Y. GONZALEZ-VELO** ; **M. N. KOZICKI**. Fabrication and characterization of Cu2O/Cu-WO3 bilayers for lateral programmable metallization cells. *AppliedSurface Science*, 2020, vol. 527, 146899
- **W. SHI** ; **X. GUO** ; **C. CUI** ; **K. JIANG** ; **Z. LI** ; **L. QU** ; **JI-CHAO WANG**. Controllable synthesis of Cu2O decorated WO3 nanosheets with dominant (001) facets for photocatalytic CO2 reduction under visible-light irradiation. *Applied Catalysis B: Environmental*, 2019, vol. 243, 236-242
- **B. SONAWANE** ; **D. R. PATIL** ; **L. A. PATIL**. CuO-Modified WO3 Sensor for the Detection of a ppm Level H2S Gas at Room Temperature. *Sensors & Transducers Journal*, 2008, vol. 93, 82-91
- **M. FENG et al.** Strong photoluminescence of nanostructured crystalline tungsten oxide thin films.. *Appl. Phys. Lett.*, 2005, vol. 86, 141901-141903
- **B. M. ALSHABANDER**. Copper (II)-doped WO3 nanoparticles with visible light photocatalytic antibacterial activity against gram-positive and gram-negative bacteria. *InorganicandNano-MetalChemistry*, 2020, 1-5
- **Y. YAO** ; **K. YAMAUCHI** ; **G. YAMAUCHI** ; **T. OCHIAI** ; **T. MURAKAMI** ; **Y. KUBOTA**. Synergistic Antibacterial Performance of a Cu/WO3-Added PTFE Particulate Superhydrophobic Composite under Visible-Light Exposur. *Journal of Biomaterials and Nanobio technology*, 2012, vol. 3, 421-430
- **YAMAUCHI** ; **T. OCHIAI** ; **G. YAMAUCHI**. The Synergistic Antibacterial Performance of a Cu/WO3-Added PTFE Particulate Superhydrophobic Composite Material.. *Journal of Biomaterials and Nanobiotechnology*, 2015, vol. 6, 1-7
- **M.N. KOZICKI** ; **C. GOPALAN** ; **M. BALAKRISH-NAN** ; **M. PARK** ; **M. MITKOVA**. Non-volatile memory based on solid electrolytes. *Proceedings of the 2004 Non-Volatile*
- **M. ZUBKINS, H. ARSLAN, L. BIKSE**. High power impulse magnetron sputtering of Zn/Al target in an Ar and Ar/O2 atmosphere: The study of sputtering process and AZO films. *Surface & Coatings Technology*, 2019, vol. 369, 156-164
- **HUANG** ; **M. MAZHAR** ; **ALI KALYAR** ; **R. F. WEBSTER** ; **D. CHERNS** ; **M. N. R. ASHFOLD**. Tungsten oxide nanorod growth by pulsed laser deposition: influence of substrate and process conditions.. *Nanoscale*, 2014, vol. 6 (22), 13586-13597
- **AGNARSSON** ; **F.MAGNUS** ; **T.K. TRYGGVASON** ; **A.S. INGASONA** ; **K. LEOSSON** ; **S. OLAFSSON** ; **J.T. GUDMUNDSSON**. Rutile TiO2 thin films grown by reactive high power impulse magnetron sputtering.. *Thin Solid Films*, 2013
- **WIDENKVIST** ; **R. A. QUINLAN** ; **B. C. HOLLOWAY** ; **H. GRENNBERG** ; **U. JANSSON**. Synthesis of nanostructured tungsten oxide thin films.. *Crystal Growth and Design*, 2008, vol. 8 (10), 3750-3753
- **HAMED NAJAFI-ASHTIANI** ; **BEHNAM AKHAVAN** ; **FENGJUAN JING** ; **MARCELA M. BILEK**. Transparent Conductive Dielectric-Metal-Dielectric Structures for Electrochromic Applications Fabricated by High-Power Impulse Magnetron Sputtering ACS Appl. Mater.. *Interfaces*
- **S.-J. LIN** ; **J. CHENG** ; **C. -FU ZHANG** ; **B. IN WANG** ; **Y.-F. ZHANG** ; **X. HUANG**. The reactivity of stoichiometric tungsten oxide clusters towards carbon monoxide: the effects of cluster sizes and charge states.. *Physical Chemistry Chemical Physics*, 2015, vol. 17 (17), 11499-11508
- **Y. YIN** ; **C. LAN** ; **H. GUO** ; **C. LI**. Reactive Sputter Deposition of WO3/Ag/WO3 Film for Indium Tin Oxide (ITO)-Free Electrochromic Devices. ACS Appl. Mater.. *Interfaces*, 2016, vol. 8, 3861-3867
- **X. ZHANG** ; **M. HUANG** ; **F. LI** ; **Z. Q. WEN**. Controlled synthesis of hierarchical CuO nanostructures for electrochemical capacitor electrodes.. *Int. J. Electrochem. Sci.*, 2013, vol. 8, 8645-8661
- **A. ANDERS**. A review comparing cathodic arcs and high power impulse magnetron sputtering (HiPIMS).. *Surf. Coat. Technol.*, 2014, vol. 257, 308-325
- **H. ARSLAN**. Indium tin oxide (ITO) coating on cylindrical surfaces: Electrical and structural characterization.. Izmir Institute of Technology, 2015
- **R. GANESAN** ; **B. AKHAVAN** ; **X. DONG** ; **D.R. MCKENZIE** ; **M.M.M. BILEK**. External Magnetic Field Increases Both Plasma Generation and Deposition Rate in HiPIMS. *Surface & Coatings Technology*, 2018, 671-679